# EUROPEAN PATENT APPLICATION

(11) **EP 3 477 186 A1**
(43) Date of publication of application: **01.05.2019**
(21) Application number: 16907771.6
(22) Date of filing: 05.07.2016
(51) Int. Cl.: F21S 9/03

(54) **PANORAMIC SENSING APPARATUS**

(71) Applicant: Bolymedia Holdings Co., Ltd., Santa Clara, CA 95051 (US)
(72) Inventor: HU, Xiaoping, Shenzhen Guangdong 518055 (CN)
(74) Representative: Manitz Finsterwald Patent- und Rechtsanwaltspartnerschaft mbB
(86) International application number: PCT/CN2016/088574
(87) International publication number: WO 2018/006266

(57) **Abstract**

A panoramic sensing apparatus, comprising: a Fresnel lens system (110) and a light sensing device (120). The Fresnel lens system (110) comprises a composite Fresnel lens (111) in a shape of a frustum, at least one of an inner surface and an outer surface of a sidewall of the frustum being a tooth surface; at least two Fresnel units are distributed on said tooth surface. The light sensing device (120) is used for sensing light rays converged by the Fresnel lens system (110). As the composite Fresnel lens in the shape of a frustum is employed for sensing boundaries of a detection range, in the case where lens areas are the same as a whole, a larger detection range may be obtained, or light energy from each direction may be collected. Further, compared with a composite Fresnel refraction surface arranged on a spherical surface or on a spherical polyhedron, the composite Fresnel refraction surface which is arranged on a sidewall of a frustum involves lowered processing difficulty, and accordingly improved precision and defect-free rate.

## Description

### Technical Field

The present disclosure relates to a technical field about panoramic sensing apparatus, more particularly to sensing apparatus which use Fresnel lenses for large field of view sensing and is suitable for panoramic or non-panoramic applications with large field of view.

### Background of the Invention

The technology of panoramic sensing has been used increasingly. With respect to the design idea of the panoramic sensing technology now available, it generally adopts "interior point detection", that is, detecting each and every point within a sensing range comprehensively and the spectrum usually sensed mainly including infrared light and visible light. Upon such detection idea, a condensing lens used is commonly designed as a spherical Fresnel lens.

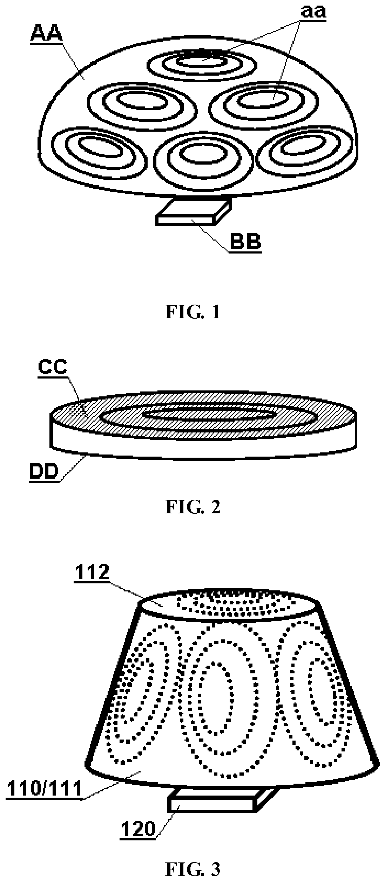

FIG. 1 shows a conventional panoramic sensing device which includes a spherical Fresnel lens AA and a light sensing device BB. The spherical Fresnel lens AA is a composite Fresnel lens having a tooth surface as its outer surface, and the tooth surface consists of a plurality of Fresnel units aa covered densely on the spherical surface. A passive infrared sensor (PIR) is adopted as the light sensing device BB.

It is very difficult to manufacture an original mold of the spherical composite Fresnel lens, especially when it is desired to arrange the tooth surface on the inner surface of the spherical surface. Therefore, as a practical matter, a spherical polyhedron is often employed to approximate the spherical surface, in which each face is firstly fabricated and then assembled into a polyhedron that is substantially spherical. It is obvious that spherical polyhedrons also have high requirements for precision in production. Moreover, there always exists a "dead zone" when realizing the idea of interior point detection with respect to the angular portion between adjacent faces of a spherical polyhedron.

On the other hand, due to the idea of interior point detection, the Fresnel units are covered densely on the surface of the spherical surface, so the area of a single Fresnel unit is relatively small, leading to a relative short sensing distance and a relative tiny coverage, which makes it difficult to achieve a wide range of panoramic sensing.

### Summary of the Invention

According to the present disclosure, a panoramic sensing apparatus comprising a Fresnel lens system and a light sensing device is provided. The Fresnel lens system may include a composite Fresnel lens shaped as a frustum, at least one of an inner surface and an outer surface of a sidewall of the frustum is a tooth surface, at least two Fresnel units are arranged on the tooth surface. The light sensing device may be configured for sensing light rays converged by Fresnel lens system.

According to the panoramic sensing apparatus of the present disclosure, a composite Fresnel lens in the shape of a frustum is used to realize the sensing of the boundary of the detection range, which is sufficient for most application scenarios where only the peripheral boundary needs to be detected. In the case where lens areas are the same as a whole, the composite Fresnel refracting surface arranged on the sidewall of the frustum only detects the boundary without having to take into account the internal points, so the sensing distance can be designed to be larger to obtain a larger detection range. Moreover, compared with the composite Fresnel refracting surface arranged on a spherical surface or a spherical polyhedron, the composite Fresnel refracting surface arranged on the sidewall of the frustum involves lowered processing difficulty, and accordingly improved precision and defect-free rate.

Since the apparatus according to the disclosure can receive optical signals from various directions, it can also be used as a light energy collector, for example, used in a solar power generation system that does not require sun tracking.

Specific examples according to the present disclosure will be described in detail below with reference to accompanying drawings.

### Brief Description of the Drawings

FIG. 1 is a schematic diagram of a conventional panoramic sensing apparatus;
FIG. 2 is a schematic diagram of a reflective Fresnel lens used in the present disclosure;
FIG. 3 is a schematic diagram of a panoramic sensing apparatus in accordance with a first embodiment of the present disclosure;
FIG. 4 is a schematic diagram of a panoramic sensing apparatus in accordance with a second embodiment of the present disclosure;
FIG. 5 is a schematic diagram of a panoramic sensing apparatus in accordance with a third embodiment of the present disclosure;
FIG. 6 is a schematic diagram of a panoramic sensing apparatus in accordance with a fourth embodiment of the present disclosure;

### Detailed Description

A Fresnel lens is employed in the panoramic sensing apparatus according to the present disclosure. For ease of understanding, relative terms will be firstly described below.

A Fresnel lens is a thin lens. It can be produced by means of dividing a continuously original curved surface of a conventional lens into a plurality of segments, reducing the thickness of each segment, and then arranging all the segments on an identical plane or a same substantially smooth curved surface. The accordingly discontinuous refracting surface evolved from the original curved surface can be referred to as Fresnel refracting surface, which generally appeared to be stepped or toothed. The Fresnel refracting surface generated by the original curved surface can be referred to as a Fresnel unit. Every Fresnel unit has its own optical center; and a plurality of "tooth" forming a Fresnel unit may form a structure of concentric circle or concentric ellipses.

A macroscopic curved surface composed of one or more Fresnel units is referred to as a tooth surface. The "macroscopic curved surface" as used herein may be a smooth surface itself with respect to the smooth surface and may be a tooth surface itself with respect to the tooth surface; in other words, it refers to a macroscopic physical shape of the entire tooth surface. A tooth surface containing only one Fresnel unit is referred to as a "simple Fresnel refracting surface"; and a tooth surface containing two or more Fresnel units is referred to as a "composite Fresnel refracting surface". A lens having a tooth surface on one side and a smooth surface on the other side may be referred to as a "single-sided Fresnel lens", and may include, for example, a "single-sided simple Fresnel lens" and a "a single-sided composite Fresnel lens". A lens having tooth surfaces on both sides may be referred to as a "double-sided Fresnel lens".

The Fresnel lens can also be combined with a reflecting surface to form a reflective Fresnel lens, for example, coating a reflecting film on one side of a single-sided or double-sided Fresnel lens, or providing a reflector on an optical path behind a Fresnel lens. Referring to FIG. 2, it shows a reflective single-sided simple Fresnel lens which has a simple Fresnel refracting surface CC on one side and a smooth surface DD coated with a reflecting film on the other side, wherein the smooth surface may be a plane, or be a concave surface or a convex surface.

The panoramic sensing apparatus according to the present disclosure will be described below with reference to specific examples. For the sake of brevity, in the following embodiments, a circular truncated cone having a circular cross section may be used to act as the frustum; while in other embodiments, a truncated cone or pyramid having other shapes in cross section may be used as the frustum, such as a truncated cone or pyramid having a square or polygonal cross section.

### First Embodiment

Referring to FIG. 3, a panoramic sensing apparatus according to the present disclosure may include a Fresnel lens system 110 and a light sensing device 120.

The Fresnel lens system 110 may include a composite Fresnel lens 111 shaped as a frustum, and the inner surface of a sidewall of the frustum is a tooth surface (indicated by a broken line in the figure) and the outer surface is smooth. In other embodiments, the tooth surface may also arranged on the outer surface of the frustum, or both the inner and outer surfaces of the frustum may be tooth surfaces.

The Fresnel lens system 110 may further include a top Fresnel lens 112 arranged on the top surface of the frustum. The "top surface" as used herein refers to an end having a smaller area, and the "bottom surface" refers to an end having a larger area. The top Fresnel lens has a planar circular shape which is in accordance with the shape of the top surface of the frustum. In this embodiment, the top Fresnel lens 112 is a single-sided simple Fresnel lens, of which the tooth surface is on the inner surface and is composed of a Fresnel unit which has a center coincided with the rotation axis of the frustum.

In this embodiment, all of the Fresnel units in the Fresnel lens system has a common focus, so that there is one light sensing device 120 arranged at the common focus (on the bottom surface of the frustum). The spectral range sensed by the light sensing device according to the present disclosure may be any one or more of the electromagnetic spectrum, such as visible light, infrared light, radar wave, radio wave, microwave, X-ray, gamma ray and the like.

The macroscopic curved surface of the Fresnel lens system of the present embodiment may include a conical surface inside the frustum and a planar surface on the top of the frustum, greatly reducing fabrication difficulty compared with manufacturing the Fresnel lens of a conventional structure of spherical surface or spherical polyhedron. Moreover, by using a large amount of lens surface area for boundary detection, it results in not only a high signal-to-noise ratio, but also a great improvement in monitoring region.

As a preferred embodiment, in the present embodiment, the Fresnel units is evenly arranged around the rotation axis of the frustum. On the one hand, it can further reduce manufacturing difficulty due to the Fresnel units uniformed in shape and distribution; on the other hand, the apparatus may stay the same in all directions with respect to detection distance and performance.

Further preferably, in the present embodiment, the Fresnel units which are around the rotation axis of the frustum and are on the inner surface of the sidewall of the frustum are arranged in only one row. In this way, the area of a single lens unit may be as large as possible, thereby further raising the monitoring range without increasing the overall area of the lens.

The apparatus of the present embodiment may not only be robust in boundary detection, but also can focus light from various directions to an identical focal plane. Therefore, it may also be used in a solar power generation system that does not provided with a sun tracking system, resulting in forming a solar system having an internal enclosure and being applicable to all directions.

### Second Embodiment

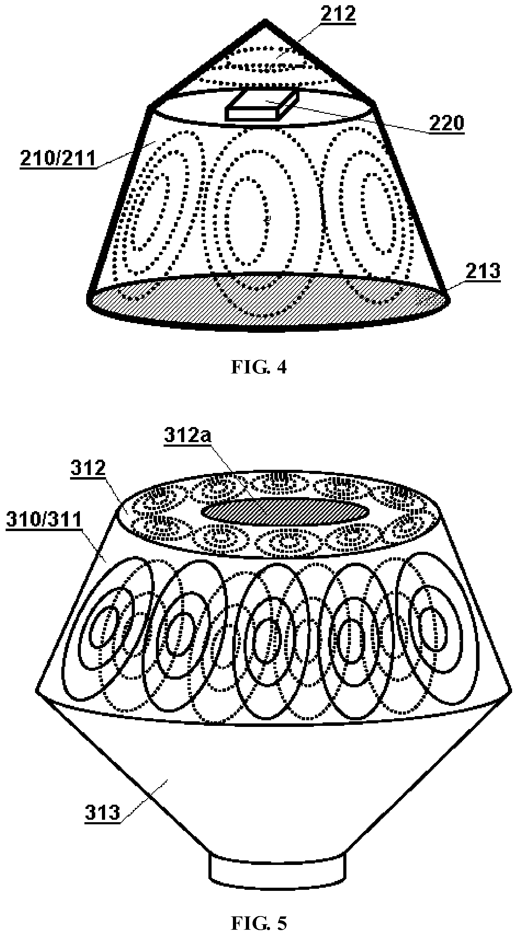

Referring to FIG. 4, a panoramic sensing apparatus according to the present disclosure may include a Fresnel lens system 210 and a light sensing device 220.

The Fresnel lens system 210 may include a composite Fresnel lens 211 shaped as a frustum, and the inner surface of a sidewall of the frustum is a tooth surface (indicated by a broken line in the figure) and the outer surface is smooth.

The Fresnel lens system 210 may further include a top Fresnel lens 212 arranged on the top surface of the frustum. The top Fresnel lens is shaped as a cone which has a bottom surface coincided with the top surface of the frustum. In this embodiment, the top Fresnel lens 212 is a single-sided simple Fresnel lens, of which the tooth surface is on the inner surface and is composed of a Fresnel unit which has a center coincided with the rotation axis of the frustum.

The Fresnel lens system 210 may further include a bottom reflector 213 arranged on the bottom surface of the frustum. The bottom reflector 213 has a planar circular shape which is in accordance with the shape of the bottom surface of the frustum. In this embodiment, the bottom reflector is a reflective Fresnel lens, in which the reflecting surface is planar and the tooth surface is a simple Fresnel refracting surface or a composite Fresnel refracting surface. In other embodiment, the bottom reflector may also be a simple planar or curved reflector.

There is one light sensing device 220 which may be a single-sided sensing device or a double-sided sensing device. It may be arranged at a common focus (on the top surface of the frustum) of each Fresnel unit in the Fresnel lens system.

In this embodiment, by using a tapered top, it benefits the protection against dust, rain and snow, preventing sensing operation from being affected. With respect to a sensing device mounted top up, it is particularly advantageous to adopt a tapered top. Moreover, the detection angle of the apparatus can be effectively increased due to the added bottom reflector. In addition, since the reflective Fresnel lens is served as the bottom reflector, light can be condensed again while being reflected, further improving signal intensity.

### Third Embodiment

Referring to FIG. 5, a panoramic sensing apparatus according to the present disclosure may include a Fresnel lens system 310 and a light sensing device (not shown).

The Fresnel lens system 310 may include a composite Fresnel lens 311 shaped as a frustum, and both the inner surface and the outer surface of a sidewall of the frustum are tooth surfaces (in the figure, the Fresnel unit of the inner surface is indicated by a broken line, and the Fresnel unit of the outer surface is indicated by a solid line). The Fresnel units on each tooth surface are evenly arranged around the rotation axis of the frustum, and the numbers of the Fresnel units on the two tooth surfaces respectively are identical. In other embodiments, the numbers of the Fresnel units on the inner and outer tooth surfaces respectively may be different. As a preferred embodiment, in the present embodiment, the centers of the Fresnel units on the inner surface and the centers of the Fresnel units on the outer surface are staggered equidistantly. Since the signal intensity of the Fresnel lens near the center is strongest, such structure can effectively extend the range of detection. In other embodiments, the centers of the Fresnel units on the inner and outer surfaces may be coincided with each other.

The Fresnel lens system 310 may further include a top Fresnel lens 312 arranged on the top surface of the frustum. The top Fresnel lens has a planar circular shape which is in accordance with the shape of the top surface of the frustum. In this embodiment, the top Fresnel lens 312 is a single-sided composite Fresnel lens, of which the tooth surface is on the inner surface, and the Fresnel units on the tooth surface are evenly arranged around the rotation axis of the frustum. As a preferred embodiment, the tooth surface of the top Fresnel lens 312 may adopt a structure in which the Fresnel units arranged peripherally encircle a center Fresnel unit 312 arranged at the center and the back surface of the center Fresnel unit is coated with a reflecting film, forming a reflective Fresnel lens.

The Fresnel lens system 310 may further include a bottom reflector 313 arranged on the bottom surface of the frustum. The bottom reflector 313 may be a specular reflector and shaped as another frustum which has a bottom surface coincided with the bottom surface of the frustum formed by the composite Fresnel lens 311. The top surface of the bottom reflector may be served as a mounting base.

There may be one or more light sensing devices (not shown) in the present embodiment. For example, a plurality of light sensing devices may be provided on the bottom reflector 313, and each light sensing device may be corresponding to a focus of one or more Fresnel units in the Fresnel lens system 310.

Two reflectors are employed in this embodiment, so the design of optical path can be more flexible so as to realize detection of large angle scope in a compact structure. Moreover, since the planar composite Fresnel lens is served as the top Fresnel lens, it is possible to detect another narrower boundary inside the detection boundary of the frustum-shaped composite Fresnel lens. This "double boundary detection" may effectively improve the reliability of the detection function of the apparatus while ensuring a relatively larger detection range.

The panoramic sensing apparatus in this embodiment can be used not only for highly reliable signal detection but also for solar energy collection and utilization.

### Fourth Embodiment

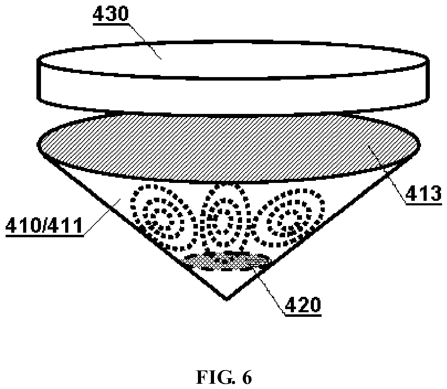

Referring to FIG. 6, a panoramic sensing apparatus according to the present disclosure may include a Fresnel lens system 410 and a light sensing device 420.

The Fresnel lens system 410 may include a composite Fresnel lens 411 shaped as a frustum, and the inner surface of a sidewall of the frustum is a tooth surface while the outer surface is smooth. The sidewall of the frustum is continuously extended upwardly from the top surface and formed as a complete tapered surface, except that the Fresnel unit is no longer arranged on a portion of the sidewall above the top surface; in this way only boundary signal is monitored in this embodiment. This closed structure with complete tapered surface may also have the advantage of the tapered top described in the second embodiment.

The Fresnel lens system 410 may further include a bottom reflector 413 arranged on the bottom surface of the frustum. The bottom reflector 413 may be a reflective Fresnel lens.

There may be one light sensing device 420 arranged at a common focus (on the top surface of the frustum) of each Fresnel unit in the Fresnel lens system.

As a preferred embodiment, the apparatus of the present embodiment may further include a solar rechargeable battery 430 that can act as a mounting base of the apparatus, and photovoltaic panels are arranged around the base. In other embodiments, the photovoltaic panels may be detachably arranged external to the sensing device. The power supply mode by solar energy may allow more flexibility and convenience in the installation and use of the apparatus without the need to connect the power cord.

In addition to the solar power supply device, other functional modules may be further included in various embodiments of the present disclosure, which may be selected and configured according to specific application scenarios or design requirements. For example, the apparatus may include:
a wireless communication module: configured for wireless communication with other devices working cooperatively wherein such other devices may be, for example, a panoramic video surveillance system, alarm system, etc., and said wireless communication may include: infrared communication, 433MHz public frequency band wireless communication, WiFi communication, Bluetooth communication , near field communication, RFID communication, etc.; with wireless communication, wiring connection may be eliminated, enhancing freedom to the use of the apparatus;
a signal analysis and processing module: configured for analyzing and processing detection signals generated by the light sensing device; and
a control module: configured for controlling the overall working state of the apparatus.

The principle and implementation manners present disclosure has been described above with reference to specific embodiments, which are merely provided for the purpose of understanding the present disclosure and are not intended to limit the present disclosure. It will be possible for those skilled in the art to make variations based on the principle of the present disclosure.

## Claims

1. A panoramic sensing apparatus, comprising:
a Fresnel lens system comprising a composite Fresnel lens comprising a composite Fresnel lens shaped as a frustum, at least one of an inner surface and an outer surface of a sidewall of the frustum being a tooth surface, at least two Fresnel units being distributed on the tooth surface; and
a light sensing device configured for sensing light rays converged by Fresnel lens system.

2. The panoramic sensing apparatus of claim 1, wherein
one of the inner surface and the outer surface of the sidewall of the frustum is a tooth surface, and the other one is a smooth surface, the Fresnel units on the tooth surface are evenly arranged around a rotation axis of the frustum; or
the inner surface and the outer surface of the sidewall of the frustum are tooth surfaces, the Fresnel units on each tooth surface is evenly arranged around the rotation axis of the frustum, and the numbers of the Fresnel units on the two tooth surfaces respectively are identical or different.

3. The panoramic sensing apparatus of claim 2, wherein
the inner surface and the outer surface of the sidewall of the frustum are tooth surface, the number of the Fresnel units on the two tooth surfaces respectively are identical, and the center of the Fresnel units on the inner surface and the center of the Fresnel units on the outer surface are coincident with one another or staggered equidistantly.

4. The panoramic sensing apparatus of any one of claims 1 to 3, wherein
the Fresnel lens system further comprises a top Fresnel lens arranged on a top surface of the frustum; and the top Fresnel lens has a planar circular shape which is in accordance with the shape of the top surface of the frustum, or the top Fresnel lens is shaped as a cone which has a bottom surface coincided with the top surface of the frustum.

5. The panoramic sensing apparatus of claim 4, wherein
the top Fresnel lens is a single-sided or double-sided simple Fresnel lens, each tooth surface consists of a Fresnel unit, and the center of the Fresnel is coincided with the rotation axis of the frustum; or
the top Fresnel lens is a single-sided or double-sided composite Fresnel lens, and the Fresnel units on each tooth surface are evenly arranged around the rotation axis of the frustum.

6. The panoramic sensing apparatus of claim 5, wherein
the top Fresnel lens is a double-sided composite Fresnel lens, the number of the Fresnel units on the two tooth surfaces respectively are identical, and the center of the Fresnel units on the inner surface and the center of the Fresnel units on the outer surface are coincident with one another or staggered equidistantly.

7. The panoramic sensing apparatus of any one of claims 1 to 6, wherein
the Fresnel lens system further comprises a bottom reflector arranged on a bottom surface of the frustum; the bottom reflector has a planar circular shape which is in accordance with the shape of the bottom surface of the frustum, or the bottom reflector is shaped as another frustum which has a bottom surface coincided with the bottom surface of the frustum.

8. The panoramic sensing apparatus of claim 7, wherein
the bottom reflector is a specular reflector or a reflective Fresnel lens, the reflecting surface of the reflective Fresnel lens is planar, the tooth surface is a simple Fresnel refracting surface or a composite Fresnel refracting surface, and the Fresnel units forming the composite Fresnel refracting surface are evenly arranged around the rotation axis of the frustum.

9. The panoramic sensing apparatus of any one of claims 1 to 8, wherein
all of the Fresnel units in the Fresnel lens system have a common focus, the number of the light sensing device is single and arranged at the common focus, and the light sensing device is a single-sided sensing device or a double-sided sensing device; or
all of the Fresnel units in the Fresnel lens system have two or more focuses, there are two or more light sensing devices and at least one light sensing device is arranged at one of the two or more focuses.

10. The panoramic sensing apparatus of any one of claims 1 to 9, wherein the light sensing device is a signal detecting device or a light energy collecting device.

11. The panoramic sensing apparatus of any one of claims 1 to 9, further comprising at least one of the following characteristics:
a rotation axis around the frustum, and the Fresnel units on the inner surface or the outer surface of the frustum being only arranged in one row;
the apparatus further comprising a solar power supply device configured for powering the apparatus with solar energy; and
the apparatus further comprising a wireless communication module configured for wirelessly communicating with an external device.
